**Europäisches Patentamt**

(19) **European Patent Office**

**Office européen des brevets**

(11) Veröffentlichungsnummer: **0 039 952**
**B1**

(12) **EUROPÄISCHE PATENTSCHRIFT**

(45) Veröffentlichungstag der Patentschrift:
22.02.84

(21) Anmeldenummer: 81103657.3

(22) Anmeldetag: 12.05.81

(51) Int. Cl.³: **H 03 K 17/687**

(54) Schalter mit einem als Source-Folger betriebenen MIS-FET.

(30) Priorität: 14.05.80 DE 3018501

(43) Veröffentlichungstag der Anmeldung:
18.11.81 Patentblatt 81/46

(45) Bekanntmachung des Hinweises auf die Patenterteilung:
22.02.84 Patentblatt 84/8

(84) Benannte Vertragsstaaten:
AT CH DE FR GB IT LI SE

(56) Entgegenhaltungen:
VMOS POWER FETS DESIGN CATALOG, Januar 1979,
FIRMA SILICONIX
ELECTRONIC EINGINEERING, Mai 1979, D. HOFFMANN
"Driving VMOS Power FETs", Seiten 29 bis 35
SIEMENS FORSCHUNGS-UND
ENTWICKLUNGSBERICHTE, Band 9, Nr. 4, 1980, Berlin;
E. HEBENSTREIT "Driving the SIPMOS Field-Effect
Transistor as a Fast Power Switch"; Seiten 200 bis 204
ELECTRON & APPLIC. IND., Nr. 259, November 1978; A.
FILLEAU "Applications des VMOS: la puissance d'une
nouvelle technologie" Seiten 19 bis 24

(73) Patentinhaber: **SIEMENS AKTIENGESELLSCHAFT,
Berlin und München Wittelsbacherplatz 2,
D-8000 München 2 (DE)**

(72) Erfinder: **Hebenstreit, Ernst, Dipl.-Ing.,
Gunzenlehstrasse 26, D-8000 München 21 (DE)**

## Schalter mit einem als Source-Folger betriebenen MIS-FET

Die Erfindung bezieht sich auf einen Schalter mit einem als Source-Folger betriebenen MIS-FET, mit einem Kondensator, der mit einem seiner Anschlüsse mit der Source-Elektrode des FET verbunden ist und der über die Schaltstrecke eines ersten Hilfstransistors die Gate-Source-Kapazität des FET aufladen kann, wobei der Kondensator mit seinem anderen Anschluß derart über eine Diode mit einer Klemme einer Spannungsquelle verbindbar ist, daß er aufgeladen wird, wenn der erste Hilfstransistor gesperrt ist, wobei ein zweiter Hilfstransistor vorgesehen ist, der beim Öffnen den ersten Hilfstransistor sperrt.

Ein solcher Schalter ist zum Beispiel im »VMOS Power FETs Design Catalog«, January 1979, Fig. 20, der Firma Siliconix beschrieben worden. In diesem Schalter sind zwei npn-Hilfstransistoren verwendet, die derart miteinander gekoppelt sind, daß beim Leitendsteuern des ersten Hilfstransistors der zweite gesperrt wird und umgekehrt. Wird der zweite Hilfstransistor gesperrt, so wird ein sogenannter Bootstrap-Kondensator von einer festen Spannung aufgeladen. Beim Leitendsteuern dieses zweiten Hilfstransistors kann sich der Bootstrap-Kondensator entladen und lädt die Gate-Source-Kapazität des FET auf die erforderliche Steuerspannung auf und steuert diesen leitend. Die bipolaren Hilfstransistoren liegen praktisch an der gleichen Spannung wie der FET.

Der Erfindung liegt die Aufgabe zugrunde, einen Schalter der eingangs beschriebenen Art so weiterzubilden, daß mit ihm ein sehr schnelles Schalten des FET möglich ist.

Die Erfindung ist gekennzeichnet durch die Merkmale:

a)   Die Spannungsquelle hat eine Spannung, die kleiner als die vom FET zu schaltende Spannung ist,

b)   der erste Hilfstransistor ist ein pnp-Transistor, und der zweite Hilfstransistor ist ein npn-Transistor, wenn der MIS-FET vom n-Kanaltyp ist und umgekehrt, wenn der MIS-FET vom p-Kanaltyp ist,

c)   der Kollektor des ersten Hilfstransistors ist mit der Steuerelektrode des FET verbunden, sein Emitter mit dem anderen Anschluß des Kondensators,

d)   der Kollektor des zweiten Hilfstransistors ist mit der Steuerelektrode des FET verbunden, sein Emitter mit der Source-Elektrode,

e)   die Basisanschlüsse der Hilfstransistoren sind über die Serienschaltung zweier Kondensatoren miteinander verbunden,

f)   die Verbindung zwischen den Kondensatoren bildet eine Klemme des Steuereingangs.

Die Merkmale a) und c) sind für sich genommen aus der Zeitschrift »Electronique & Application Industrielle«, Paris, No. 259, November 1978, Seite 23, Fig. 11b, im Prinzip bekannt. Ein sehr schnelles Schalten des FET ist hier jedoch nicht möglich, da sich die Gate-Source-Kapazität des FET hier nur über die angeschlossene Last entladen kann. Das Merkmal d) ist für sich zum Beispiel aus der Zeitschrift »Electronic Engineering«, May 1979, Seite 33, Fig. 4, bekannt. Besondere Maßnahmen zum schnellen Ein- und Ausschalten des FET sind hier jedoch offensichtlich nicht vorgesehen.

Eine vorteilhafte Wirkung des Anmeldungsgegenstandes besteht darin, daß die Hilfstransistoren für kleinere Sperrspannung als der FET ausgelegt werden können. Diese Vorteile werden zwar auch mit den aus den obengenannten Zeitschriften bekannten Schaltungen erreicht, jedoch nicht in Verbindung mit einem schnellen Ein- und Ausschalten des FET.

Weiterbildungen der Erfindung sind Gegenstand der Unteransprüche.

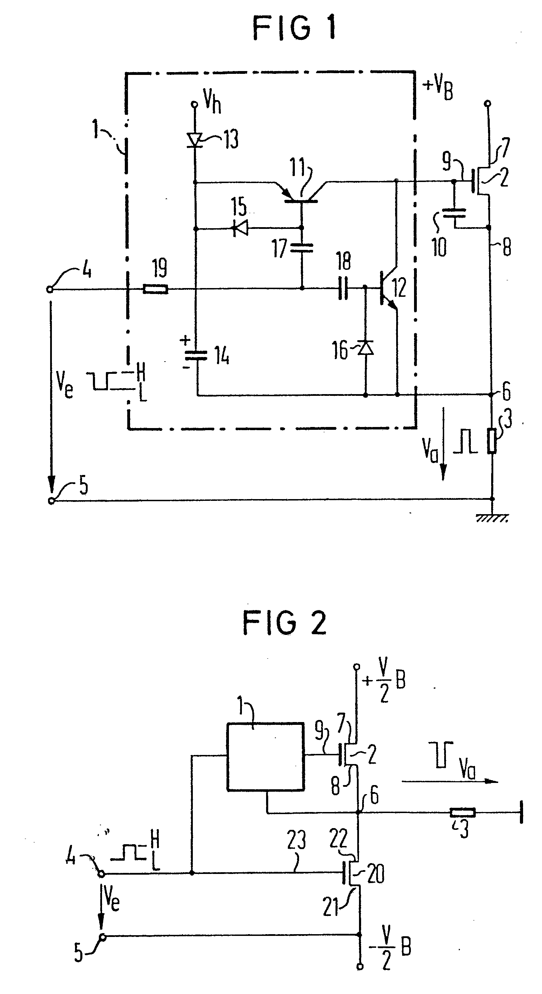

Die Erfindung wird an Hand zweier Ausführungsbeispiele in Verbindung mit den Fig. 1 und 2 näher erläutert. Es zeigt

Fig. 1 einen Ein-Aus-Schalter und

Fig. 2 einen aus dem Schalter nach Fig. 1 entwickelten Umschalter.

Der Schalter nach Fig. 1 besteht im wesentlichen aus einem Steuerteil 1, aus einem Leistungs-MIS-FET 2 (Metal Isolated Semiconductor-Feldeffekttransistor), der in Reihe mit einer Last 3 an einer Versorgungsspannung $+V_B$ liegt. Die Last liegt zwischen der Source-Elektrode 8 des FET und Masse. Der FET 2 wird daher als sogenannter Source-Folger betrieben. Solche Schalter sind vorteilhaft zum Beispiel für Drosselwandler verwendbar. Der Steuerteil 1 des Schalters, der von der gestrichelten Linie umrandet ist, weist zwei zueinander komplementäre Hilfstransistoren 11 und 12 auf. Ist der FET 2 vom n-Kanaltyp, so ist der Hilfstransistor 11 ein pnp-Transistor und der Hilfstransistor 12 ein npn-Transistor. Bei einem p-Kanal FET wären die Hilfstransistoren vom npn- bzw. pnp-Typ. Der Hilfstransistor 12 liegt der Gate-Source-Strecke des FET 2 parallel, die durch die Gate-Source-Kapazität 10 gekennzeichnet ist. Der Kapazität 10 ist außerdem die Reihenschaltung aus der Kollektor-Emitter-Strecke des Hilfstransistors 11 mit einem Bootstrap-Kondensator 14 parallel geschaltet. Dieser Kondensator 14 liegt außerdem mit einem Anschluß über eine Diode 13 an einer Hilfsspannungsquelle mit der Spannung $+V_h$. Diese Hilfsspannung kann beispielsweise 10 V betragen, während die Versorgungsspannung $+V_B$ bei 50 bis 100 V oder höher liegen kann. Der andere Anschluß des Kondensators 14 ist mit der Source-Elektrode 8 des FET 2 verbunden. Die Drain-Elektrode 7 liegt an positiver Spannung. Die Steuerelektroden beider Hilfstransistoren 11, 12 sind über Kondensatoren 17, 18 miteinander verbunden. Der Verbindungspunkt bildet die Eingangsklemme 4 des Schalters, wobei je nach Eigenschaft der Steuerspannungsquelle noch ein Widerstand 19 zwischengeschaltet sein kann. Die zweite Eingangsklemme des Schalters ist mit 5 bezeichnet. Sie liegt an Masse. Zur Ausschaltung der Richtwirkung der Emitter-Basis-Strecken der Hilfstransistoren 11 und 12 können diesen Dioden 15, 16 antiparallel geschaltet sein. Die Dioden können auch durch Widerstände ersetzt werden.

Zur Erläuterung der Funktion des Schalters sei zunächst angenommen, daß der Bootstrap-Kondensator 14 über die Hilfsspannung $V_h$ mit der angegebenen Polarität aufgeladen ist. Nun werde die Steuerspannung $v_e$ an den Klemmen 4 und 5 vom Pegel H auf den Pegel L erniedrigt. Damit wird dem Basisanschluß des Hilfstransistors 11 über den Kondensator 17 ein negativer Steuerimpuls zugeführt, der den Hilfstransistor 11 öffnet. Damit kann sich der Kondensator 14 entladen und lädt die Kapazität 10 über die Emitter-Kollektor-Strecke des Hilfstransistors 11 auf. Damit beginnt der FET 2 zu leiten, und das Potential am Punkt 6 steigt. Gleichzeitig erhöht sich das Potential an der Steuerelektrode 9 des FET 2, während die Entladung des Kondensators 14 so lange andauert, bis die Kapazität 10 aufgeladen ist. Dazu muß der Kondensator 14 größer als die Kapazität 10 sein. Gleichzeitig mit dem Leitendsteuern des Hilfstransistors 11 wird der Hilfstransistor 12 durch denselben negativen Impuls gesperrt. Der Hilfstransistor 12 bleibt auch gesperrt, wenn er durch Abklingen eines positiven kapazitiven Steuerstroms bereits gesperrt sein sollte. Die Entladung der Kapazität 10 über diesen Hilfstransistor wird damit vermieden. Der FET 2 bleibt nun solange geöffnet, wie die Kapazität 10 mit einer Spannung geladen ist, die über der Einsatzspannung des FET liegt.

Zum Ausschalten des FET wird der Pegel der Eingangsspannung $v_e$ auf den Wert H erhöht. Die Basiselektrode des Hilfstransistors 12 erhält somit einen positiven Spannungsimpuls, der den Hilfstransistor 12 öffnet. Der positive Spannungsimpuls bewirkt gleichzeitig ein Sperren des pnp-Transistors 11. Der Hilfstransistor 11 bleibt auch gesperrt, wenn er durch Abklingen eines negativen kapazitiven Steuerstroms bereits gesperrt ist. Damit wird die Kapazität 10 entladen, und der FET 2 kann sperren. Das Potential am Punkt 6 sinkt nun so weit, daß der Kondensator 14 über die Diode 13 von der Hilfsspannungsquelle erneut aufgeladen werden kann.

Aus der Erläuterung der Wirkungsweise ergibt sich, daß am Hilfstransistor 12 maximal die Steuerspannung des FET 2, das heißt, die Hilfsspannung $V_h$ vermindert um die Schwellspannung der Diode 13 und die Kollektor-Emitter-Restspannung des Transistors 12 am Transistor 11 anliegt. Andererseits liegt am Hilfstransistor 11 im gesperrten Zustand nur die Steuerspannung des FET 2, die im wesentlichen der Hilfsspannung $V_h$, vermindert um die Schwellspannung der Diode 13, entspricht.

Mit der erläuterten Schaltungsanordnung ist ein sehr schnelles Schalten des FET 2 möglich, da durch die beschriebene Verknüpfung der beiden Hilfstransistoren 11 und 12 eine dynamische Mitkopplung erzielt wird: Beim Einschalten des Schalters, das heißt, beim Übergang der Steuerspannung $v_e$ auf den Pegel L, tritt, bedingt durch den Potentialanstieg am Punkt 6, zusätzlich zum negativen Steuerimpuls am Hilfstransistor 11 ein Spannungsanstieg am Emitter des Hilfstransistors 11 auf. Dadurch wird ein beschleunigtes Einschalten dieses Transistors erzielt. Der Potentialanstieg am Punkt 6 sperrt auch den Hilfstransistor 12 schnell, indem er seinen Emitter in bezug auf die Basis positiv vorspannt. Beim Übergang der Eingangsspannung $v_e$ auf den Pegel H beschleunigt sich das Ausschalten des Hilfstransistors 11 und das Einschalten des Hilfstransistors 12. Damit kann der FET 2 sehr schnell gesperrt werden.

In Fig. 2 ist ein Umschalter dargestellt, mit dem die Last 3 abwechselnd an eine positive Spannung $+1/2\,V_B$ und an eine negative Spannung $-1/2\,V_B$ geschaltet werden kann. Dazu ist der Schalter nach Fig. 1 um einen zweiten FET 20 vom gleichen Kanaltyp ergänzt. Der Source-Anschluß des FET 20 ist mit 21 bezeichnet, sein Drain-Anschluß mit 22 und sein Gate-Anschluß mit 23. Der Source-Anschluß 8 und der Drain-Anschluß 22 der FET sind miteinander verbunden. Am Verbindungspunkt 6 liegt außerdem ein Anschluß der Last und der Steuerschaltung 1. Der Gate-Anschluß des FET 20 ist mit der einen Eingangsklemme 4 verbunden, während der Source-Anschluß 21 praktisch die andere Klemme 5 des Schalters bildet.

Der FET 2 wird durch Übergang der Eingangsspannung vom Pegel H auf den Pegel L wie in Verbindung mit Fig. 1 beschrieben eingeschaltet. Damit ist der FET 20 gesperrt, und an der Last 3 liegt eine positive Spannung der Höhe $+1/2\,V_B$. Beim Übergang der Eingangsspannung auf den Pegel H wird wie in Verbindung mit Fig. 1 beschrieben der FET 2 gesperrt. Die Gate-Elektrode 23 des FET 20 erhält nun eine positive Spannung gegenüber dem Punkt 6, und der FET 20 wird eingeschaltet. An der Last 3 liegt dann eine negative Spannung der Größe $-1/2\,V_B$.

## Patentansprüche

1. Schalter mit einem als Source-Folger betriebenen MIS-FET (2), mit einem Kondensator (14), der mit einem seiner Anschlüsse mit der Source-Elektrode (8) des FET verbunden ist und der über die Schaltstrecke eines ersten Hilfstransistors (11) die Gate-Source-Kapazität des FET aufladen kann, wobei der Kondensator (14) mit seinem anderen Anschluß derart über eine Diode (13) mit einer Klemme einer Spannungsquelle ($V_h$) verbindbar ist, daß er aufgeladen wird, wenn der erste Hilfstransistor (11) gesperrt ist, wobei ein zweiter Hilfstransistor (12) vorgesehen ist, der beim Öffnen den ersten Hilfstransistor (11) sperrt, gekennzeichnet durch die Merkmale:

a) die Spannungsquelle hat eine Spannung (V$_h$), die kleiner als die vom FET (2) zu schaltende Spannung ist,

b) der erste Hilfstransistor (11) ist ein pnp-Transistor und der zweite Hilfstransistor (12) ein npn-Transistor, wenn der MIS-FET vom n-Kanaltyp ist und umgekehrt, wenn der MIS-FET vom p-Kanaltyp ist,

c) der Kollektor des ersten Hilfstransistors (11) ist mit der Steuerelektrode (9) des FET (2) verbunden, sein Emitter mit dem anderen Anschluß des Kondensators (14),

d) der Kollektor des zweiten Hilfstransistors (12) ist mit der Steuerelektrode (9) des FET (2) verbunden, sein Emitter mit der Source-Elektrode (8),

e) die Basisanschlüsse der Hilfstransistoren (11, 12) sind über die Serienschaltung zweier Kondensatoren (17, 18) miteinander verbunden,

f) die Verbindung zwischen den Kondensatoren (17, 18) bildet eine Klemme (4) des Steuereingangs.

2. Schalter nach Anspruch 1, dadurch gekennzeichnet, daß den Emitter-Basis-Strecken der Hilfstransistoren (11, 12) je eine Diode (15, 16) antiparallel geschaltet ist.

3. Schalter nach Anspruch 1, dadurch gekennzeichnet, daß den Emitter-Basis-Strecken der Hilfstransistoren je ein Widerstand parallel geschaltet ist.

4. Schalter nach einem der Ansprüche 1 bis 3, gekennzeichnet durch die Merkmale:

a) mit der Source-Elektrode (8) des FET (2) (erster FET) ist die Drain-Elektrode (22) eines zweiten FET (20) vom gleichen Typ verbunden,

b) die Drain-Elektrode (7) des ersten FET (2) liegt an positivem Potential, die Source-Elektrode (21) des zweiten FET (20) liegt an negativem Potential, jeweils bezogen auf die Source- bzw. Drain-Elektroden,

c) die Source-Elektrode (8) des ersten FET (2) und die Drain-Elektrode (22) des zweiten FET (20) sind mit einem Anschluß der Last (3) verbunden,

d) die Steuerelektrode des zweiten FET (20) ist mit der genannten einen Klemme (4) des Steuereingangs verbunden,

e) die andere Klemme (5) des Steuereingangs ist mit der Source-Elektrode (21) des zweiten FET (20) verbunden.

## Claims

1. A switch with a MIS-FET (2) operated as a source-follower, a capacitor (14) connected by one of its terminals to the source electrode (8) of the FET, and which can charge the gate-source-capacitance of the FET via the controlled path of a first auxiliary transistor (11), the capacitor (14) being connectable by its other terminal via a diode (13) to a terminal of a voltage sourve (V$_h$) in such manner that it becomes charged when the first auxiliary transistor (11) is non-conductive, a second auxiliary transistor (12) being provided which is rendered non-conductive when the first auxiliary transistor (11) is rendered conductive, characterised by the following features:

a) the voltage source possesses a voltage (V$_h$) smaller in magnitude than the voltage to be switched by the FET (2),

b) the first auxiliary transistor (11) is a pnp-transistor and the second auxiliary transistor (12) is an npn-transistor if the MIS-FET is of the n-channel type, and vice versa when the MIS-FET is of the p-channel type,

c) the collector of the first auxiliary transistor (11) is connected to the control electrodes (9) of the FET (2), whereas its emitter is connected to the other terminal of the capacitor (14),

d) the collector of the second auxiliary transistor (12) is connected to the control electrode (9) of the FET (2), whereas its emitter is connected to the source electrode (8),

e) the base terminals of the auxiliary transistors (11, 12) are connected to one another via the series arrangement of two capacitors (17, 18),

f) the connection between the capacitors (17, 18) forms one terminal (4) of the control input.

2. A switch as claimed in Claim 1, characterised in that a diode (15, 16) is connected anti-parallel to the emitter-base paths of each of the auxiliary transistors (11, 12).

3. A switch as claimed in Claim 1, characterised in that a resistor is connected in parallel to the emitter-base paths of each of the auxiliary transistors.

4. A switch as claimed in one of the Claims 1 to 3, characterised by the following features:

a) the source electrode (8) of the FET (2) (first FET) is connected to the drain electrode (22) of a second FET (20) of the same type,

b) the drain electrode (7) of the first FET (2) is connected to positive potential, whereas the source electrode (21) of the second FET (20) is connected to negative potential, in each case relative to the source or drain electrode, as the case may be,

c) the source elektrode (8) of the first FET (2) and the drain electrode (22) of the second FET (20) are connected to a terminal of the load (3),

d) the control electrode of the second FET (20) is connected to the aforementioned first terminal (4) of the control input,

e) the other terminal (5) of the control input is connected to the source electrode (21) of the second FET (20).

## Revendications

1. Commutateur comportant un transistor à effet de champ (MIS) fonctionnant en tant que source suiveuse, et un condensateur (14) qui est relié par l'une de ses bornes à l'électrode de source (8) du transistor à effet de champ et qui peut charger, par l'intermédiaire de la voie de commande d'un premier transistor auxiliaire (11), la capacité grille-source du transistor à effet de champ, l'autre borne du condensateur (14) pouvant être reliée par l'intermédiaire d'une diode (13) à une borne d'une source de tension ($V_h$) de telle sorte qu'il est chargé lorsque le premier transistor auxiliaire (11) est bloqué, tandis qu'il est prévu un second transistor auxiliaire (12) qui se bloque lors du passage à l'état conducteur du premier transistor auxiliaire (11), remarquable par les caractéristiques:

a) la source de tension possède une tension ($V_h$) qui est inférieure à la tension devant être commutée par le transistor à effet de champ (2),

b) le premier transistor auxiliaire (11) est un transistor pnp et le second transistor auxiliaire (12) est un transistor pnp lorsque le transistor à effet de champ MIS est du type à canal n et inversement lorsque le transistor à effet de champ MIS est du type à canal p,

c) le collecteur du premier transistor auxiliaire (11) est relié à l'électrode de commande (9) du transistor à effet de champ (2), et son émetteur est relié à l'autre borne du condensateur (14),

d) le collecteur du second transistor auxiliaire (12) est relié à l'électrode de commande (9) du transistor à effet de champ (2) et son émetteur est relié à l'électrode de source (8),

e) les bornes des bases des transistors auxiliaires (11, 12) sont reliées entre elles par l'intermédiaire du montage série de deux condensateurs (17, 18),

f) la liaison entre les condensateurs (17, 18) forme une borne (4) de l'entrée de commande.

2. Commutateur suivant la revendication 1, caractérisé par le fait que des diodes respectives (15, 16) sont branchées selon un montage anti-parallèle avec les voies émetteur-base des transistors auxiliaires (11, 12).

3. Commutateur suivant la revendication 1, caractérisé par le fait que des résistances respectives sont branchées selon un montage antiparallèle avec les voies émetteur-base des transistors auxiliaires.

4. Commutateur suivant l'une des revendications 1 à 3, caractérisé par les caractéristiques:

a) à l'électrode de source (8) du transistor à effet de champ (2) (premier transistor à effet de champ) est reliée l'électrode de drain (22) d'un seconde transistor à effet de champ (20) du même type,

b) l'électrode de drain (7) du premier transistor à effet de champ (2) est placée à un potentiel positif et l'électrode de source (21) du second transistor à effet de champ (20) est placée à un potentiel négatif, respectivement par rapport aux électrodes de source et de drain,

c) l'électrode de source (8, 22) du premier transistor à effet de champ (2) et l'électrode de drain (22) du second transistor à effet de champ sont reliées à une borne de la charge (3),

d) l'électrode de commande du second transistor à effet de champ (20) est reliée à l'une des bornes indiquées (4) de l'entrée de commande,

e) l'autre borne (5) de l'entrée de commande est reliée à l'électrode de source (21) du second transistor à effet de champ (20).

# FIG 1

# FIG 2